# EUROPEAN PATENT SPECIFICATION

(11) **EP 1 884 150 B1**
(45) Date of publication and mention of the grant of the patent: **22.07.2009**
(21) Application number: 06727051.2
(22) Date of filing: 09.05.2006
(51) Int. Cl.: H05K 9/00, H01K 1/02

(54) **IMPROVED PRINTED CIRCUIT BOARD ASSEMBLY**
VERBESSERTE LEITERPLATTENBAUGRUPPE
PLAQUETTE DE CIRCUITS IMPRIMES AMELIOREE

(30) Priority: 27.05.2005 GB 0510925
(43) Date of publication of application: 06.02.2008
(73) Proprietor: Arka Technologies Limited, London E1 6BT (GB)
(72) Inventor: ROCHFORD, Craig, Hampshire SP11 8AS (GB)
(74) Representative: Bennett, Adrian Robert J.
(86) International application number: PCT/GB2006/001688
(87) International publication number: WO 2006/125947

(56) References cited:
- WO-A-02/30170
- DE-A1- 3 642 151
- DE-U1- 29 515 035
- FR-A1- 2 838 914

## Description

The present invention relates to printed circuit board (PCB) assemblies and particularly, but not exclusively, to a system for shielding components from radio frequency interference (RFI) and more particularly to a system for shielding surface mounted devices (SMD).

It is well known in the design of electrical equipment to reduce the undesirable affects of RFI by shielding components mounted on a printed circuit board (PCB) with a shielding can manufactured from an electrically conductive materials such as beryllium copper. This type of shielding can has hitherto for been traditionally mounted to a PCB with surface mounting techniques such as soldering. However, a problem associated with these techniques, is that once secured in position on a PCB, a shielding can can not be readily removed. As a consequence, the replacement or repair of devices covered by the shield is considerably complicated. Any subsequent redesign of a PCB provided with a shielding can is also complicated and expensive.

It is an object of the present invention to provide a system for allowing a component to be securely mounted to a PCB.

The present invention provides a printed circuit board (PCB) assembly according to the appended claim 1.

In use of the present invention, the or each barb may be provided on the RF shielding can so as to be engageable with a slug on the printed circuit board, and in this way a gripping engagement between the circuit board and the RF shielding can is achieved which retains the printed circuit board and RF shielding can in position relative to one another. This use of a barb provides a simple and relatively inexpensive means for securing a printed circuit board and RF shielding can together.

The present invention also provides a printed circuit board assembly comprising further novel and advantageous features as recited in any of the appended dependent claims 2 to 21.

Embodiments of the present invention will now be described with reference to the accompanying drawings in which:
Figure 1 is a perspective view of a printed circuit board (PCB) assembly according to the present invention;
Figure 2 is a plan view of the Radio Frequency (RF) shielding can of the PCB assembly shown in Figure 1;
Figure 3 is a side view of the RF shielding can shown in Figure 2;
Figure 4 is an enlarged plan view of a portion of the RF shielding can shown in Figure 2;
Figure 5 is an enlarged perspective view of means by which the RF shielding can is attached to the PCB in Figure 1;
Figure 6 is a further enlarged perspective view of means by which the RF shielding can is attached to the PCB in Figure 1;
Figure 7 is a yet enlarged perspective view of means by which the RF shielding can is attached to the PCB in Figure 1;
Figure 8 is a fourth enlarged perspective view of means by which the RF shielding can is attached to the PCB in Figure 1;
Figure 9 is an enlarged plan view of a portion of an alternative RF shielding can to that shown in Figure 2;
Figure 10 is an enlarged plan view of a portion of a second RF shielding can to that shown in Figure 2;
Figure 11 is an enlarged plan view of a portion of a third RF shielding can to that shown in Figure 2;
Figure 12 is a bottom plan view of an assembly tool;
Figure 13 is a cross-sectional side view of the assembly tool taken along line A-A of Figure 12;
Figure 14 is top plan view of the assembly tool shown in Figure 12;
Figures 15 to 17 are perspective views of an alternative embodiment of the invention;
Figures 18 to 20 are perspective views of the embodiment of Figures 15 to 17 when fully assembled;
Figures 21 to 23 are perspective views of another embodiment of the invention; and
Figures 24 to 26 are perspective views of the embodiment of Figures 21 to 23 when fully assembled.

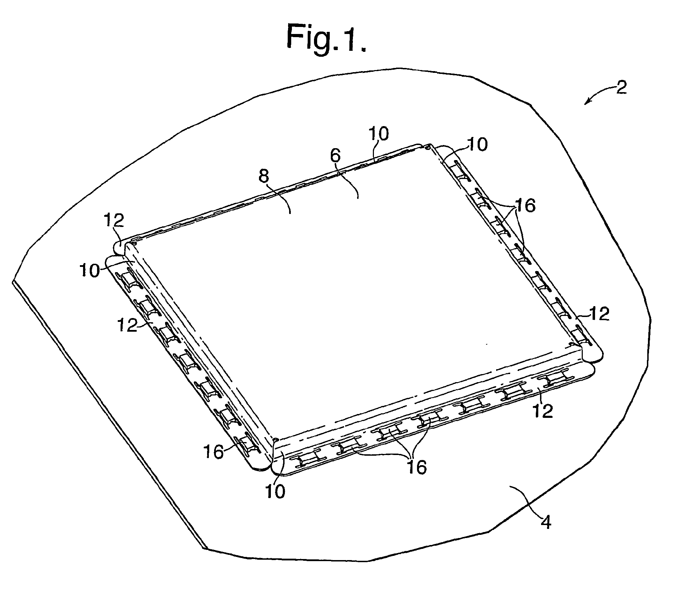

A printed circuit board (PCB) assembly 2 according to the present invention is shown in Figure 1 of the accompanying drawings as comprising a printed circuit board (PCB) 4 to which is mounted a RF shielding can 6. The shielding can typically encloses one or more electrical components (not shown).

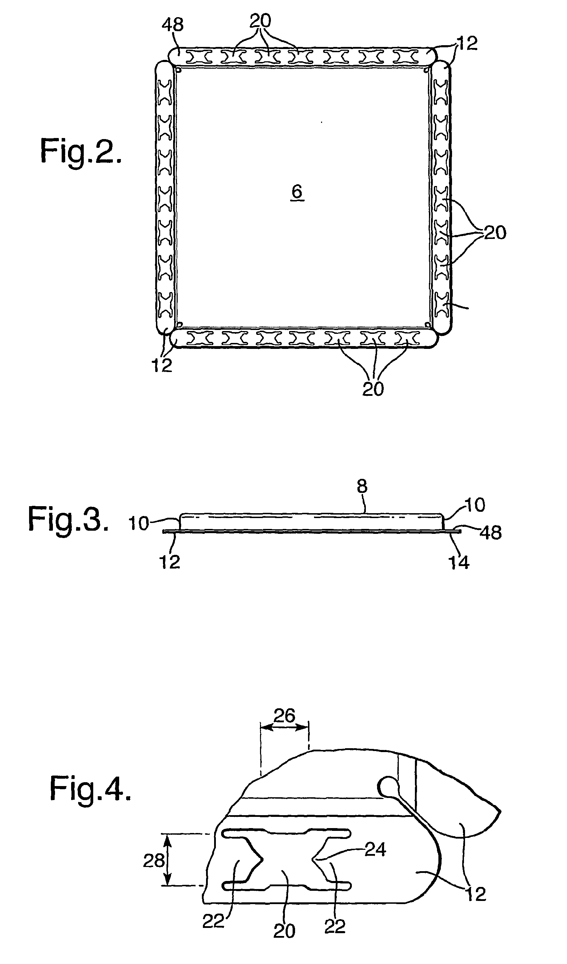

The RF shielding can 4 comprises a square upper surface 8 from the edges of which four side portions 10 are downwardly bent through 90°. The five surfaces of a box are thereby formed. It will also be understood from the accompanying drawings that a flange element 12 is bent outwardly through 90° from each side surface 10 so as to provide an abutment surface 14 (see Figure 3) with the PCB 4.

The RF shielding can 6 is manufactured from stainless steel, however it will be understood that other materials and alternative shapes for the shielding can 6 may be used.

The shielding can 6 is secured to the PCB 4 by securing means comprising a plurality of slugs 16 which are attached to the PCB 4 and extend upwardly from a surface thereof through a plurality of apertures provided in each flange element 12 of the shielding can 6. As will be described in greater detail below, each slug 16 extends into an aperture provided in a flange element 12 and thereby engages with the flange element 12 in such a way as to prevent a ready return of the slug 16 from the respective aperture. Each slug 16 is provided as a rectangular block, however alternative shapes will be apparent to a reader skilled in the art. Ideally, the slugs 16 should be of a relatively simple and symmetrical shape so that they may be manufactured relatively inexpensively and be conveniently positioned in large quantities on the PCB 4 by conventional pick-and-place manufacturing techniques. Each slug 16 may be attached to the PCB 4 with solder 18 or other suitable adhesive.

It will be appreciated with reference to the accompanying drawings that the slugs 16 are positioned so as to align with the apertures 20 (see Figure 2 in particular) provided along each flange element 12. The relative geometry of the slugs 16 and the RF shielding can 6 is such that, as the flange elements 12 are brought into abutment with the PCB 4 during assembly, each slug 16 projects from one side of an aperture 20 to the other side thereof. In so doing, two barbs 22 extending from opposite perimeter edges of each aperture 20 are deflected by each slug 16.

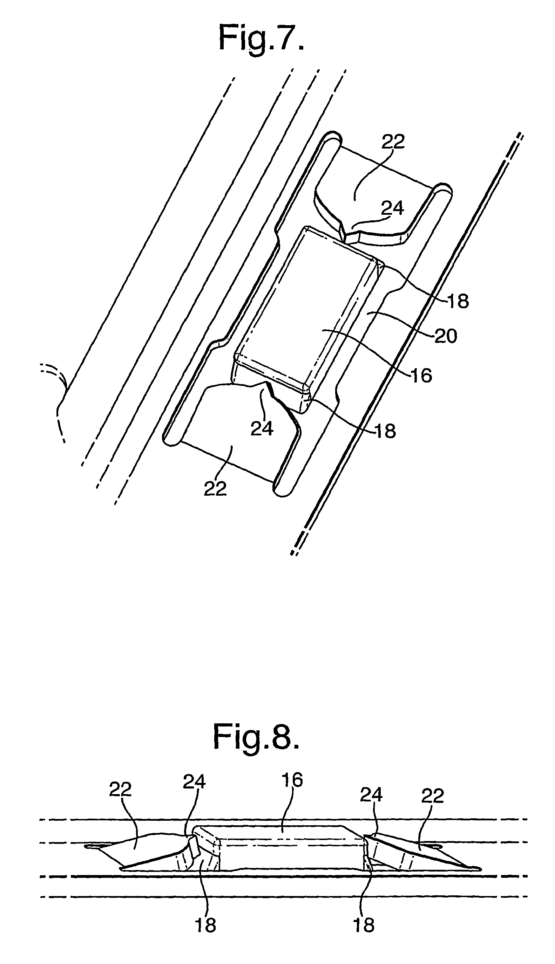

In the embodiments shown in Figures 1 to 8 of the accompanying drawings, each aperture 20 has a generally rectangular shape and the two barbs 22 extend from the shorter sides of the rectangle towards the centre of the aperture 20. The barbs 22 each terminate in a point 24 which, in use, tends to penetrate the material of a slug 16 or the solder 18 attaching the slug 16 to the PCB 4. It will be appreciated that the distance between the two points 24 associated with an aperture 20 is less than the associated dimension of the slug 16 to be located in the aperture 20 so that, when the slug 16 is pressed through the aperture 20, the slug 16 abuts each opposing barb 22 and upwardly deflects each barb 22 (see Figure 8). As a slug 16 is pressed through an aperture 20 and bends each barb 22 upwardly from the plane of the respective flange element 12, the point 24 of each barb 22 penetrates the slug and/or solder and thereby prevents a ready return of the slug 16 from the aperture 20. A firm securing of the RF shielding can 6 to the PCB 4 is achieved as a consequence.

Although alternative arrangements will be apparent to a reader skilled in the art, the shielding can 6 is stamped and bent from a sheet of stainless steel material having a thickness of 0.2 mm. The distance 26 between the points 24 is 1.2 mm and the width 28 of each aperture 20 is 1.2 mm. It will be understood that each barb 22 is conveniently formed from the material of the RF shielding can 6 when each aperture 20 is stamped therein.

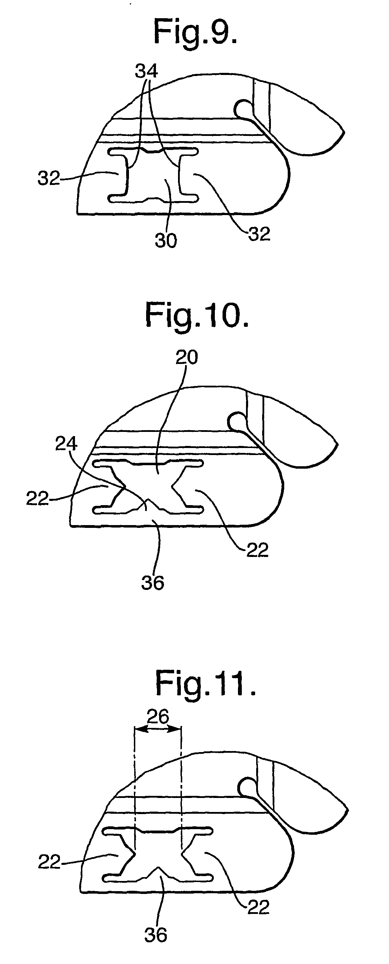

It will be understood that alternative barb arrangements may be provided. An example of different arrangements for the barbs is shown in Figures 9 to 11 of the accompanying drawings. In Figure 9, an aperture 30 is shown with barbs 32 similar to the barbs 22 of Figures 1 to 8 but without the point 24. In this arrangement, the opposing edges 34 of the barbs 32 (and which engage a slug 16 in use) are ideally chamfered or otherwise sharpened so as to increase the tendency for penetration into the material of the slug or the solder attaching the slug to the PCB.

In Figure 10, the arrangement of Figures 1 to 8 has been modified with the addition of a third barb 36 extending laterally towards the centre of the aperture 20 from a third side of the rectangular aperture 20. The third barb 36 has a shorter length than the first and second barbs 22 but, like the first and second barbs 22, has a point 24 which assists in penetrating a slug or the solder associated therewith. A yet further arrangement is shown in Figure 11 which is identical to that of Figure 10 other than that the distance 26 between the points 24 of the first and second barbs 22 has been increased from 1.2 mm to 1.3 mm.

It will be understood that a fourth barb may also be provided so that a barb extends from each straight side of a square or rectangular aperture. Each barb will be positioned so as to be deflected when a slug 16 is inserted through the associated aperture.

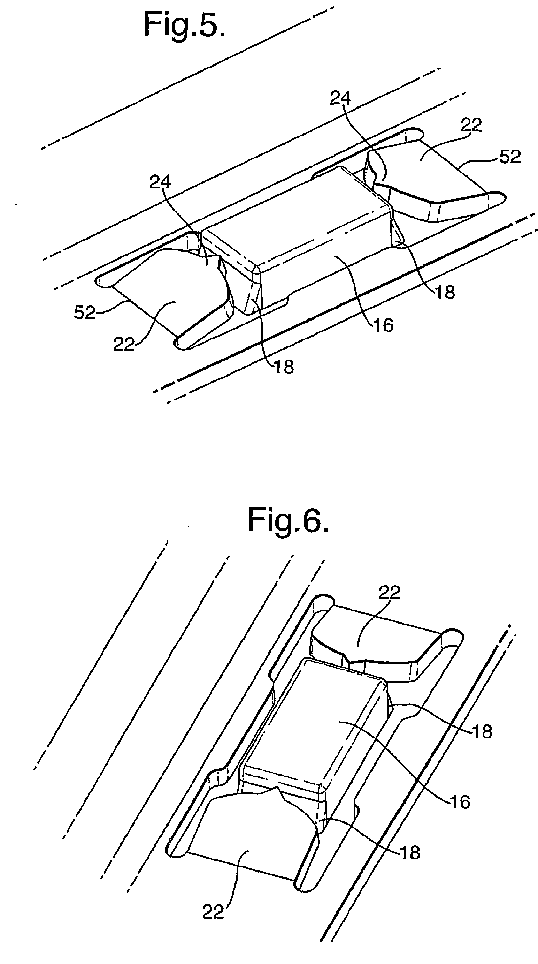

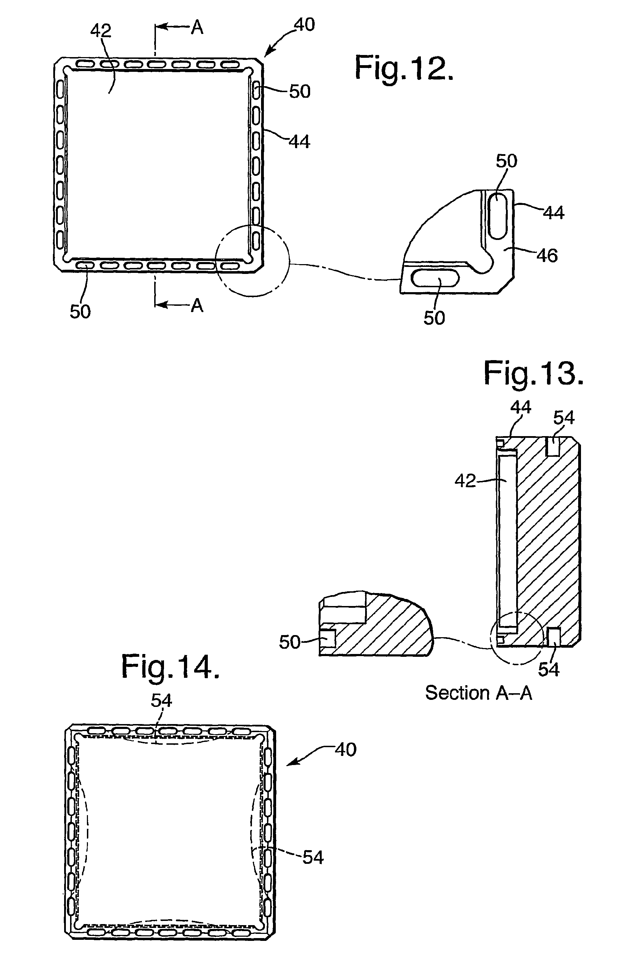

The pressing of the flange elements 12 over a plurality of slugs 16 provided on a PCB 4 is assisted by means of an assembly tool 40 such as that shown in Figures 12 to 14. The assembly tool 40 comprises a block of material (for example, stainless steel) having a recess 42 defined in a bottom surface thereof. The recess 42 is sized and shaped, and has sufficient depth, to receive the upper surface 8 and side surfaces 10 of the RF shielding can 6 to be secured to the PCB 4. A perimeter wall 44 extending around the recess 42 has the same or similar plan footprint as the combined flange elements 12 of the shielding can 6. The arrangement is such that the lower surface 46 of the perimeter wall 44 is engageable with an upper surface 48 (see Figure 3) of the shielding can flange elements 12 so that the flange elements 12 may be evenly pressed along their length in a downward direction towards the PCB 4. In order to allow the slugs 16 to project through the apertures in the flange elements 12 and to also allow the barbs 22, 36 to be bent upwardly, the lower surface 46 of the perimeter wall 44 is provided with a plurality of recesses 50 which, during manufacture of the PCB assembly 2, each receive a slug 16 and the barbs 22, 36 associated with the aperture through which said slug projects. Each recess 50 may be sized and shaped so that its perimeter locates along a fold line 52 (see Figure 5) associated with each barb so as to encourage a particular bending of each barb.

As shown in Figures 13 and 14 of the accompanying drawings, the assembly tool 40 is provided with a slot 54 in each of its four sides which facilitates the gripping of the tool 40 either by hand or by automated machinery.

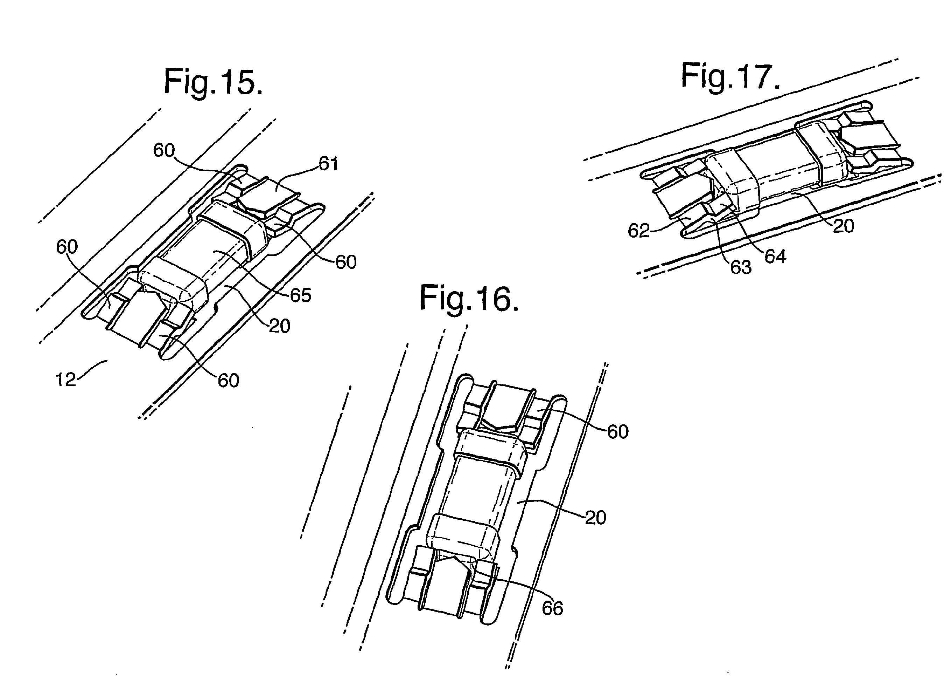

Figs 15 to 20 show an alternative embodiment of the invention wherein the flange 12 includes one or more tabs 60 in addition to the barbs, for contact with the slugs 65. More specifically, a tab 60 is disposed in each of the four corner regions of the apertures 20. The barbs 61 of this embodiment are narrower than the barbs 22 discussed above, thus allowing space for the tabs 60 either side of the barbs 61. Prior to engagement of the shielding can 6 with the PCB 4, the barbs 61 and tabs 60 lie in the plane of the flange 12, and as a result of engaging with the slugs 65 the barbs and tabs are bent upwardly out of the plane of the flange 12.

The barbs and/or tabs of all the embodiments disclosed herein are not bent beyond their elastic limit in the procedure of applying the shielding can 6 to the PCB 4, whereby the shield can be removed and re-applied to the same or a different PCB a number of times.

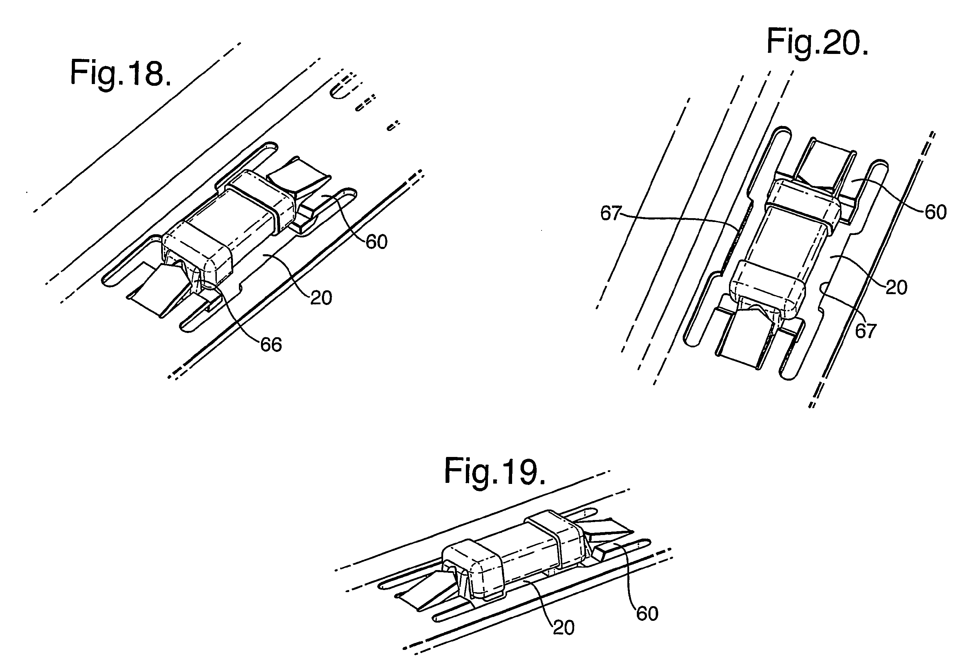

As shown by Fig. 17, each tab 60 comprises a proximal tab portion 62 connected to the flange 12, a medial tab portion 63 adjoining the proximal tab portion 62 and angled downwardly therefrom, and a distal tab portion 64 connected to the medial tab portion 63 and parallel to the proximal tab member 62, each tab 60 thereby comprising a stepped tongue which can resiliently engage under at least part of the slug 65. The stepped profile of the tab 60 adds to its resilience, which resilience allows the tabs 60 to be moved from their positions shown in Figs 15 to 17, abutting the end faces of the slug 65, to their positions shown in Figs 18 to 20, engaging underneath the slug 65. Once engaged under the slug 65, the tabs 60 enhance the securing of the RF shielding can to the PCB 4. The barbs 61 can engage into solder 66 which is used to hold the slugs 65 to the PCB 4, in this case, the soldering 66 being particularly localised so as not to prevent the tabs 60 moving to their engaged position under the slug 65.

As shown in Fig 20, the flange 12 includes a ridge 67 at the longitudinal edges of each aperture 20, which ridge 67 protrudes slightly into the aperture 20. The ridges 67 can act to prevent lateral motion of the flange 12 relative to the PCB 4, to a given tolerance, and to guide the shielding can 6 as it is brought into position over the slugs 65.

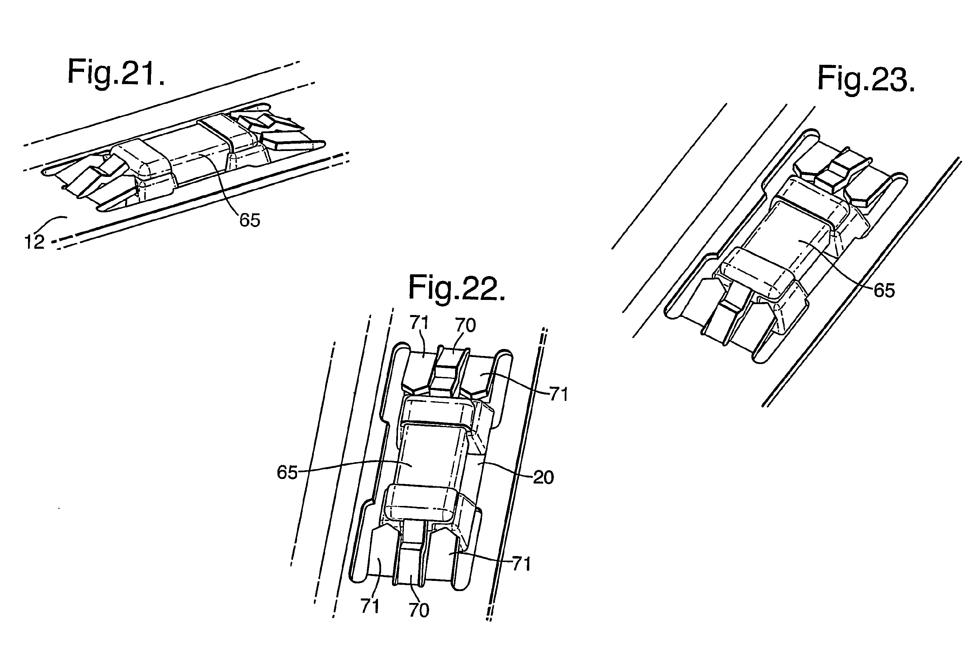

Figs 21 to 26 show another embodiment where, in contrast to the previous embodiment, the flange 12 includes barbs 71 in each of the four corner regions of the apertures 20 and a tab 70 situated at each end of the aperture, located in between the barbs 71. As with the previous embodiments, the barbs 71 and tabs 70 slant upwardly away from the plane of the flange 12, when the shielding can has initially been pressed over the slugs. The tabs 70 again each comprise a stepped tongue for engaging resiliently underneath the slug 65.

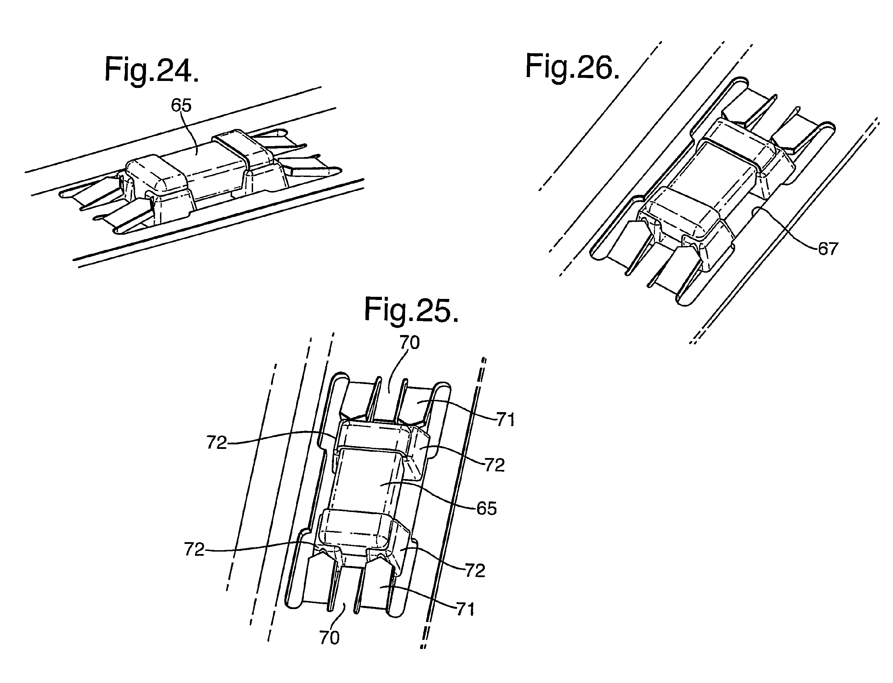

The slug 65 is connected to the PCB 4 by soldering 72 at each of the four corners of the slug 65, sufficient space being left between the solder joints 72 to allow the tabs 70 to move into their engaged position, which is shown in Figs 24 to 26.

Advantageously, in the embodiments shown in Figs 15 to 26, the slugs 65 comprise readily available components for use with PCBs, such as resistors. Such slugs can be used with any of the embodiments disclosed herein. The use of readily available components avoids the need for the design and development of a custom-built slug thereby reducing costs. It is possible to use a zero-ohm resistor, these being particularly cheap compared to other resistance values. As its name suggests, a zero-ohm resistor has a very small resistance and can be seen as a conductor. The electrical properties of the component as such are not critical; it is the size, shape and to some extent, physical strength of the component which determines its usability. However, if the barbs and/or tabs of the flange 12 are metallic, the component forming the slug is electrically connected to the shielding can 6, and thus contributes to the efficacy of the shielding effect, by having a grounding effect on the shielding can 6, especially when a zero-ohm resistor is used. Other resistance values such as 50 ohms and 75 ohms can also be used.

In the embodiments of Figs 15 to 26, the pressing of the flanges 12 over the slugs 65 is assisted by means of the assembly tool 40 mentioned above, with suitable means added for pressing the tabs 60,70 downwardly to engage or clip under the slugs 65, whilst avoiding pressing down the barbs 61,71. Such means can comprise abutments (not shown in the drawings) provided in the recesses 50 to line up with the tabs and avoid the barbs.

The present invention is not limited to the particular embodiments described above. Alternative arrangements and suitable materials will be apparent to a reader skilled in the art. For example, it will be apparent that a shielding can may be provided with barbs which engage directly with an electrical component to be shielded (or with the solder attaching said component to the PCB).

## Claims

1. A printed circuit board (PCB) assembly (2) comprising a printed circuit board (4) and a Radio Frequency (RF) shielding cant(6) mounted thereon, wherein the printed circuit board (4) and RF shielding can (6) are secured to one another by securing means comprising a plurality of slugs (16) extending upwardly from a surface of the PCB (4), each slug being receivable in an aperture (20) provided in the material of said RF shielding can (6), and **characterised in that** at least one barb (22) is provided at the perimeter of each aperture (20), said barb (22) being configured to bend and to penetrate the slug (16) received in each aperture (20).

2. A PCB assembly (2) as claimed in claim 1, wherein a second barb (22) extends from the perimeter of said aperture.

3. A PCB assembly (2) as claimed in claim 2, wherein the first and second barbs (22) are located on opposite sides of each aperture (20) and extend towards one another.

4. A PCB assembly (2) as claimed in any of claims 1 to 3, wherein four barbs (22) are provided, each of which is located in a corner region of the aperture (20).

5. A PCB assembly (2) as claimed in any of the preceding claims, wherein the or each barb (22) comprises a length of material terminating in a point.

6. A PCB assembly (2) as claimed in any of the preceding claims, wherein the or each barb (22) comprises a length of material which is resiliently flexible.

7. A PCB assembly (2) as claimed in claim 6, wherein the barb (22) is not flexed beyond its elastic limit when the RF shielding can (6) is secured to the PCB (4).

8. A PCB assembly (2) as claimed in any of the preceding claims, wherein the or each barb (22) extends from said RF shielding can (6) and penetrates adhesive securing a slug (16) to the PCB (4).

9. A PCB assembly (2) as claimed in claim 8, wherein said adhesive is solder (18).

10. A PCB assembly (2) as claimed in any of the preceding claims, wherein said slug (16) comprises an electrical component such as a resistor.

11. A PCB assembly (2) as claimed in claim 10, wherein the resistor (16) is a zero-ohm resistor.

12. A PCB assembly (2) as claimed in any of the preceding claims, wherein the securing means further comprises at least one tab (60).

13. A PCB assembly (2) as claimed in claim 12 wherein the tab (60) extends from the perimeter of an aperture (20) provided in the material of said RF shielding can.

14. A PCB assembly (2) as claimed in claim 13 wherein a second tab (60) extends from the perimeter of said aperture (20).

15. A PCB assembly (2) as claimed in claim 14, wherein the two tabs (60) are located on opposite sides of said aperture (20) and extend towards one another.

16. A PCB assembly (2) as claimed in any of claims 12 to 15, wherein the or each tab (60) comprises a length of material which is resiliently flexible.

17. A PCB assembly (2) as claimed in claim 16, wherein the tab (60) is not flexed beyond its elastic limit.

18. A PCB assembly (2) as claimed in any of claims 12 to 17, wherein the or each tab (60) engages under at least part of a slug (16).

19. A PCB assembly (2) as claimed in any of claims 12 to 18, wherein the or each barb (22) is located in between a pair of tabs (60).

20. A PCB assembly (2) as claimed in any of claims 12 to 18, wherein the or each tab (60) is located in between a pair of barbs (22).

21. A PCB assembly (2) as claimed in any of claims 12 to 20, wherein the respective sizes of said slug (16) and said aperture (20) is such that, when said slug (16) is received in said aperture (20), at least one tab (60) is resiliently bent, and then pushed into engagement under the slug (16).

## Patentansprüche

1. Leiterplattenanordnung (2), die eine Leiterplatte (4) und einen daran angebrachten Hochfrequenz(HF)-Abschirmbecher (6) umfasst, wobei die Leiterplatte (4) und der HF-Abschirmbecher (6) mit Befestigungseinrichtungen aneinander befestigt sind, die eine Vielzahl von Blöcken (16) umfassen, die sich von einer Oberfläche der Leiterplatte (4) nach oben erstrecken, und jeder Block in einer Öffnung (20) aufgenommen werden kann, die in dem Material des HF-Abschirmbechers (6) vorhanden ist, **dadurch gekennzeichnet, dass** wenigstens ein Widerhaken (22) am Umfang jeder Öffnung (20) vorhanden ist und der Widerhaken (22) so ausgeführt ist, dass er sich biegt und in den Block (16) eindringt, der in jeder Öffnung (20) aufgenommen ist.

2. Leiterplattenanordnung (2) nach Anspruch 1, wobei sich ein zweiter Widerhaken (22) vom Umfang der Öffnung aus erstreckt.

3. Leiterplattenanordnung (2) nach Anspruch 2, wobei sich der erste und der zweite Widerhaken (22) an einander gegenüberliegenden Seiten jeder Öffnung (20) befinden und sich aufeinander zu erstrecken.

4. Leiterplattenanordnung (2) nach einem der Ansprüche 1 bis 3, wobei vier Widerhaken (22) vorhanden sind, von denen sich jeder in einem Eckenbereich der Öffnung (20) befindet.

5. Leiterplattenanordnung (2) nach einem der vorangehenden Ansprüche, wobei der oder jeder Widerhaken (22) einen Abschnitt aus Material umfasst, der in einer Spitze endet.

6. Leiterplattenanordnung (2) nach einem der vorangehenden Ansprüche, wobei der oder jeder Widerhaken (22) einen Abschnitt aus Material umfasst, der federnd flexibel ist.

7. Leiterplattenanordnung (2) nach Anspruch 6, wobei der Widerhaken (22) nicht über seine Elastizitätsgrenze hinaus gebogen wird, wenn der HF-Abschirmbecher (6) an der Leiterplatte (4) befestigt wird.

8. Leiterplattenanordnung (2) nach einem der vorangehenden Ansprüche, wobei sich der oder jeder Widerhaken (22) von dem HF-Abschirmbecher (6) aus erstreckt und in Haftmittel eindringt, mit dem ein Block (16) an der Leiterplatte (4) befestigt ist.

9. Leiterplattenanordnung (2) nach Anspruch 8, wobei das Haftmittel Lötmetall (18) ist.

10. Leiterplattenanordnung (2) nach einem der vorangehenden Ansprüche, wobei der Block (16) ein elektrisches Bauteil, wie beispielsweise einen Widerstand, umfasst.

11. Leiterplattenanordnung (2) nach Anspruch 10, wobei der Widerstand (16) ein Null-Ohm-Widerstand ist.

12. Leiterplattenanordnung (2) nach einem der vorangehenden Ansprüche, wobei die Befestigungseinrichtung des Weiteren wenigstens eine Zunge (60) umfasst.

13. Leiterplattenanordnung (2) nach Anspruch 12, wobei sich die Zunge (60) vom Umfang einer Öffnung (20) aus erstreckt, die in dem Material des HF-Abschirmbechers vorhanden ist.

14. Leiterplattenanordnung (2) nach Anspruch 13, wobei sich eine zweite Zunge (60) von dem Umfang der Öffnung (20) aus erstreckt.

15. Leiterplattenanordnung (2) nach Anspruch 14, wobei sich die zwei Zungen (60) an einander gegenüberliegenden Seiten der Öffnung (20) befinden und sich aufeinander zu erstrecken.

16. Leiterplattenanordnung (2) nach einem der Ansprüche 12 bis 15, wobei die oder jede Zunge (60) einen Abschnitt aus Material umfasst, der elastisch flexibel ist.

17. Leiterplattenanordnung (2) nach Anspruch 16, wobei die Zunge (60) nicht über ihre Elastizitätsgrenze hinaus gebogen wird.

18. Leiterplattenanordnung (2) nach einem der Ansprüche 12 bis 17, wobei die oder jede Zunge (60) unter wenigstens einen Teil eines Blocks (16) eingreift.

19. Leiterplattenanordnung (2) nach einem der Ansprüche 12 bis 18, wobei sich der oder jeder Widerhaken (22) zwischen paarigen Zungen (60) befindet.

20. Leiterplattenanordnung (2) nach einem der Ansprüche 12 bis 18, wobei sich die oder jede Zunge (60) zwischen paarigen Widerhaken (22) befindet.

21. Leiterplattenanordnung (2) nach einem der Ansprüche 12 bis 20, wobei die jeweiligen Größen des Blocks (16) und der Öffnung (20) so sind, dass, wenn der Block (16) in der Öffnung (20) aufgenommen wird, wenigstens eine Zunge (60) federnd gebogen und dann unter den Block (16) in Eingriff geschoben wird.

## Revendications

1. Ensemble (2) de carte à circuit imprimé (PCB) comprenant une carte à circuit imprimé (4) et un capot (6) de blindage radioélectrique (HF) qui est monté dessus, dans lequel la PCB (4) et le capot (6) de blindage HF sont fixés l'un à l'autre à l'aide de moyens de fixation qui comprennent une pluralité de pions (16) qui s'étendent vers le haut à partir d'une surface de la carte à circuit imprimé (4), chaque pion pouvant être reçu dans une ouverture (20) disposée dans le matériau dudit capot (6) de blindage HF, et **caractérisé en ce qu'**au moins un ergot (22) est fourni au niveau du périmètre de chaque ouverture (20), ledit ergot (22) étant configuré de manière à fléchir et à pénétrer dans le pion (16) reçu dans chaque ouverture (20).

2. Ensemble de PCB (2) selon la revendication 1, dans lequel un deuxième ergot (22) s'étend à partir du périmètre de ladite ouverture.

3. Ensemble de PCB (2) selon la revendication 2, dans lequel les premier et deuxième ergots (22) se situent sur les côtés opposés de chaque ouverture (20) et s'étendent l'un vers l'autre.

4. Ensemble de PCB (2) selon l'une quelconque des revendications 1 à 3,
dans lequel quatre ergots (22) sont prévus, chacun d'eux étant situé dans une région de coin de l'ouverture (20).

5. Ensemble de PCB (2) selon l'une quelconque des revendications précédentes, dans lequel le ou chaque ergot (22) comprend une longueur de matériau qui se termine en une pointe.

6. Ensemble de PCB (2) selon l'une quelconque des revendications précédentes, dans lequel le ou chaque ergot (22) comprend une longueur de matériau qui est flexible de manière élastique.

7. Ensemble de PCB (2) selon la revendication 6, dans lequel l'ergot (22) n'est pas fléchi au-delà de sa limite d'élasticité lorsque le capot (6) de blindage HF est fixé à la PCB (4).

8. Ensemble de PCB (2) selon l'une quelconque des revendications précédentes, dans lequel le ou chaque ergot (22) s'étend à partir dudit capot (6) de blindage HF et pénètre dans l'adhésif qui fixe un pion (16) à la PCB (4).

9. Ensemble de PCB (2) selon la revendication 8, dans lequel ledit adhésif est de la soudure (18).

10. Ensemble de PCB (2) selon l'une quelconque des revendications précédentes, dans lequel ledit pion (16) comprend un composant électrique tel qu'une résistance.

11. Ensemble de PCB (2) selon la revendication 10, dans lequel la résistance (16) est une résistance de zéro ohm.

12. Ensemble de PCB (2) selon l'une quelconque des revendications précédentes, dans lequel les moyens de fixation comprennent en outre au moins une languette (60).

13. Ensemble de PCB (2) selon la revendication 12, dans lequel la languette (60) s'étend à partir du périmètre d'une ouverture (20) disposée dans le matériau dudit capot de blindage HF.

14. Ensemble de PCB (2) selon la revendication 13, dans lequel une deuxième languette (60) s'étend à partir du périmètre de ladite ouverture (20).

15. Ensemble de PCB (2) selon la revendication 14, dans lequel les deux languettes (60) se situent sur les côtés opposés de ladite ouverture (20) et s'étendent l'une vers l'autre.

16. Ensemble de PCB (2) selon l'une quelconque des revendications 12 à 15,
dans lequel la ou chaque languette (60) comprend une longueur de matériau qui est flexible de manière élastique.

17. Ensemble de PCB (2) selon la revendication 16, dans lequel la languette (60) n'est pas fléchie au-delà de sa limite d'élasticité.

18. Ensemble de PCB (2) selon l'une quelconque des revendications 12 à 17,
dans lequel la ou chaque languette (60) vient en prise par dessous avec une partie au moins d'un pion (16).

19. Ensemble de PCB (2) selon l'une quelconque des revendications 12 à 18,
dans lequel le ou chaque ergot (22) se situe entre une paire de languettes (60).

20. Ensemble de PCB (2) selon l'une quelconque des revendications 12 à 18,
dans lequel la ou chaque languette (60) se situe entre une paire d'ergots (22).

21. Ensemble de PCB (2) selon l'une quelconque des revendications 12 à 20, dans lequel les dimensions respectives dudit pion (16) et de ladite ouverture (20) sont telles que, lorsque ledit pion (16) est reçu dans ladite ouverture (20), au moins une languette (60) est fléchie de manière élastique, et poussée ensuite dans une mise en prise sous le pion (16).
